# EUROPEAN PATENT APPLICATION

(11) **EP 4 083 254 A1**
(43) Date of publication of application: **02.11.2022**
(21) Application number: 22169186.8
(22) Date of filing: 21.04.2022
(51) Int. Cl.: C23C 30/00, C23C 28/04, C23C 28/00, C23C 14/06, C23C 14/32

(54) **HARD FILM FOR CUTTING TOOL**

(30) Priority: 26.04.2021 JP 2021074007; 25.03.2022 JP 2022050572
(71) Applicant: UNION TOOL CO., Tokyo (JP)
(72) Inventor: SUZUKI, Shuntaro, Tokyo (JP); SATO, Akira, Tokyo (JP)
(74) Representative: Kramer Barske Schmidtchen Patentanwälte PartG mbB

(57) **Abstract**

Provided is a hard film for a cutting tool that exhibits exceptional abrasion resistance. The hard film for a cutting tool includes a first film layer that comes in contact with a workpiece. The first film layer is obtained by laminating one or both of a nitride layer (A) that is formed from Al and Cr and that contains unavoidable impurities, and a nitride layer (B) that is formed from Al, Cr, and Cu and that contains unavoidable impurities, together with a nitride layer (C) that is formed from Al and four elements selected from among Ti, Nb, Cr, V, Ta, Zr, and B and that contains unavoidable impurities. Furthermore, the amount of Al in the nitride layer (C) is 30-60 mol% (inclusive), and the amounts of the elements other than Al in the nitride layer (C) are within ±5 mol% of the equivalent (equivalent: (100-(amount of Al in nitride layer C))/4).

## Description

### TECHNICAL FIELD

The present invention relates to a hard film for a cutting tool with which a cutting tool such as an end mill or drill is coated.

### BACKGROUND ART

An AlCrN coating such as that disclosed in, e.g., Patent Document 1 is known as an exceptionally abrasion-resistant hard film for a cutting tool that is coated on a cutting tool such as an end mill or drill.

AlCrN is widely used in hard films for cutting tools due to having exceptional heat resistance as well.

### [Prior Art Documents]

### [Patent Documents]

[Patent Document 1] Japanese Laid-open Patent Application No. 10-25566

### DISCLOSURE OF THE INVENTION

### PROBLEMS THE INVENTION IS INTENDED TO SOLVE

The inventors conducted further research and development with respect to a hard film for a cutting tool having exceptional abrasion resistance and heat resistance as described above, and developed an innovative hard film for a cutting tool exhibiting abrasion resistance superior to that of a prior-art hard film for a cutting tool that is formed from an AlCrN single-layer film (referred to below as the "prior-art example").

### MEANS FOR SOLVING THE PROBLEMS

The main points of the present invention are described below.

The present invention relates to a hard film for a cutting tool that is formed on a substrate, the hard film for a cutting tool being characterized in that: a first film layer that comes in contact with a workpiece is included therein, the first film layer being obtained by laminating one or both of a nitride layer A that is formed from Al and Cr and that contains unavoidable impurities, and a nitride layer B that is formed from Al, Cr, and Cu and that contains unavoidable impurities, together with a nitride layer C that is formed from Al and four elements selected from among Ti, Nb, Cr, V, Ta, Zr, and B and that contains unavoidable impurities; the amount of Al in the nitride layer C is 30-60 mol% (inclusive); and the amounts of the various elements other than Al in the nitride layer C are within ±5 mol% of the equivalent (equivalent: (100-(amount of Al in nitride layer C))/4).

The present invention also relates to the hard film for a cutting tool according to the first aspect, characterized in that the first film layer is obtained by laminating a plurality of nitride layers A and nitride layers C.

The present invention also relates to the hard film for a cutting tool according to the first aspect, characterized in that the first film layer is obtained by laminating a plurality of nitride layers B and nitride layers C.

The present invention also relates to the hard film for a cutting tool according to the first aspect, characterized in that the first film layer is obtained by laminating a plurality of nitride layers A, nitride layers B, and nitride layers C.

The present invention also relates to the hard film for a cutting tool according to any of the first, third, and fourth aspects, characterized in that the amount of Cu in the nitride layer B is 5 mol% or less.

The present invention also relates to the hard film for a cutting tool according to any of the first to fifth aspects, characterized by being formed from the first film layer and a second film layer provided under the first film layer, the second film layer being a nitride layer D that is formed from Al and Cr and that contains unavoidable impurities, or a nitride layer E that is formed from Al, Cr, and Cu and that contains unavoidable impurities.

The present invention also relates to the hard film for a cutting tool according to the sixth aspect, characterized in that the second film layer is the nitride layer D, and the amount of Cr in the nitride layer D is 30-50 mol% (inclusive).

The present invention also relates to the hard film for a cutting tool according to the sixth or seventh aspect, characterized in that the nitride layer D has the same composition as the nitride layer A.

The present invention also relates to the hard film for a cutting tool according to the sixth aspect, characterized in that the second film layer is the nitride layer E, and the amount of Cr in the nitride layer E is 30-50 mol% (inclusive).

The present invention also relates to the hard film for a cutting tool according to the sixth or ninth aspect, characterized in that the nitride layer E has the same composition as the nitride layer B.

The present invention also relates to the hard film for a cutting tool according to any of the first to fifth aspects, characterized by being formed from the first film layer and a second film layer provided under the first film layer, the second film layer being obtained by laminating a nitride layer D that is formed from Al and Cr and that contains unavoidable impurities, and a nitride layer E that is formed from Al, Cr, and Cu and that contains unavoidable impurities.

The present invention also relates to the hard film for a cutting tool according to the eleventh aspect, characterized in that the average value of the amounts of Cr in each of the nitride layer D and the nitride layer E of the second film layer is 30-50 mol% (inclusive) .

The present invention also relates to the hard film for a cutting tool according to the eleventh or twelfth aspect, characterized in that the nitride layer D has the same composition as the nitride layer A, and the nitride layer E has the same composition as the nitride layer B.

The present invention also relates to the hard film for a cutting tool according to any of the eleventh to thirteenth aspects, characterized in that the second film layer is obtained by laminating a plurality of nitride layers D and nitride layers E.

The present invention also relates to the hard film for a cutting tool according to any of the sixth and ninth to fourteenth aspects, characterized in that the amount of Cu in the nitride layer E is 5 mol% or less.

The present invention also relates to the hard film for a cutting tool according to the first aspect, characterized in that: the first film layer is obtained by laminating the nitride layer A, the nitride layer B, and the nitride layer C; the nitride layer A is formed from (Al₇₀Cr₃₀)N, in which the metallic components are represented by Al₇₀Cr₃₀ (the numerals expressing the molar percentage), and which contains at least N as a nonmetallic element and also contains unavoidable impurities; the nitride layer B is formed from (Al_{49.5}Cr_{49.5}Cu₁)N, in which the metallic components are represented by Al_{49.5}Cr_{49.5}Cu₁ (the numerals expressing the molar percentage), and which contains at least N as a nonmetallic element and also contains unavoidable impurities; and the nitride layer C is formed from (Al₄₀Ti₁₅Nb₁₅Cr₁₅V₁₅)N, in which the metallic components are represented by Al₄₀Ti₁₅Nb₁₅Cr₁₅V₁₅ (the numerals expressing the molar percentage), and which contains at least N as a nonmetallic element and also contains unavoidable impurities.

The present invention also relates to the hard film for a cutting tool according to the sixteenth aspect, characterized by being formed from the first film layer and a second film layer provided under the first film layer, the second film layer being obtained by laminating a nitride layer D that is formed from Al and Cr and that contains unavoidable impurities, and a nitride layer E that is formed from Al, Cr, and Cu and that contains unavoidable impurities, the nitride layer D having the same composition as the nitride layer A, and the nitride layer E having the same composition as the nitride layer B.

The present invention also relates to the hard film for a cutting tool according to any of the first to seventeenth aspects, characterized by having a bottom layer formed directly on the substrate, the bottom layer being formed from a nitride or carbonitride of Ti.

### EFFECT OF THE INVENTION

Due to being configured in the manner described above, the present invention is a hard film for a cutting tool that exhibits abrasion resistance superior to that in the prior-art example.

Therefore, coating a substrate of a cutting tool with the hard film for a cutting tool of the present invention minimizes damage to the cutting tool and increases the tool service life to a greater extent than when the cutting tool is coated with the prior-art example.

### BRIEF DESCRIPTION OF THE DRAWINGS

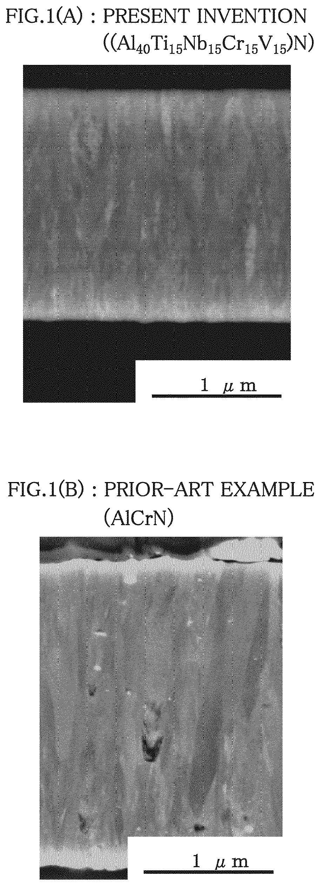

FIG. 1(A) is a crystal structure diagram (reflected-electron image) of one specific example (AlTiNbCrVN) of a nitride layer C in the present invention, and FIG. 1(B) is a crystal structure diagram (reflected-electron image) of a prior-art example (AlCrN).

### BEST MODE FOR CARRYING OUT THE INVENTION

Preferred embodiments of the present invention are briefly described below with reference to the diagrams while indicating the effects of the present invention.

FIG. 1(A) is a crystal structure diagram (reflected-electron image) of one specific example (where the four elements Ti, Nb, Cr, and V are selected from among Ti, Nb, Cr, V, Ta, Zr, and B, and AlTiNbCrVN is formed) of a nitride layer C in the present invention, and FIG. 1(B) is a crystal structure diagram (reflected-electron image) of a prior-art example.

As shown in FIG. 1(A), the crystal grains in the nitride layer C of the present invention are smaller than those in the prior-art example in FIG. 1(B); therefore, the nitride layer C promises effects such as minimized propagation of cracks at the crystal grain boundaries and improved hardness associated with the Hall-Petch effect, and exceptional abrasion resistance can be obtained (this is considered to be because the nitride layer C of the present invention contains a plurality of metallic elements, whereby the entropy of mixing is high in the same manner as with high-entropy alloys, and a high-entropy effect, lattice strain effect, and low-diffusion properties are exhibited). In the present description, the metallic elements also include semimetallic elements.

In the present invention, because the nitride layer C is included in a first film layer that comes in contact with a workpiece, there is obtained a hard film for a cutting tool that exhibits abrasion resistance superior to that of an AlCrN film, and damage to a cutting tool is minimized and the tool service life is increased to a greater extent than when the cutting tool is coated with the prior-art example.

### [Example 1]

A specific example 1 of the present invention is described below.

The present example relates to a hard film for a cutting tool that is formed on a substrate, the hard film being such that a first film layer that comes in contact with a workpiece is obtained by laminating one or both of a nitride layer A that is formed from Al and Cr and that contains unavoidable impurities (referred to below simply as the "nitride layer A"), and a nitride layer B that is formed from Al, Cr, and Cu and that contains unavoidable impurities (referred to below simply as the "nitride layer B"), together with a nitride layer C that is formed from Al and four metallic elements selected from among Ti, Nb, Cr, V, Ta, Zr, and B and that contains unavoidable impurities (referred to below simply as the "nitride layer C").

Specifically, the present example relates to a hard film for a cutting tool formed from: the first film layer (outermost layer); a second film layer (intermediate layer) provided directly under the first film layer, the second film layer being obtained by laminating a nitride layer D that is formed from Al and Cr and that contains unavoidable impurities (referred to below simply as the "nitride layer D"), and a nitride layer E that is formed from Al, Cr, and Cu and that contains unavoidable impurities (referred to below simply as the "nitride layer E"); and a bottom layer (adhesion layer) provided directly under the second film layer and directly on the substrate, the bottom layer being formed from a nitride or carbonitride that has Ti as a main component.

The various constituent parts according to the present example are described in detail below.

The first film layer of the present example is obtained by laminating the nitride layer A, the nitride layer B, and the nitride layer C.

Specifically, the nitride layer A is formed from AlCrN, in which the metallic components are represented by Al_{(*m*)}Cr_{(*n*)} (where m+n=100 (mol%)), and which contains at least N as a nonmetallic element and also contains unavoidable impurities.

More specifically, the nitride layer A of the present example is formed from (Al₇₀Cr₃₀)N and is set to a thickness of 0.01-0.02 µm.

The nitride layer A is not limited to (Al₇₀Cr₃₀)N, and may be, e.g., (Al₆₀Cr₄₀)N, (Al₅₀Cr₅₀)N, or (Al₄₀Cr₆₀)N.

The nitride layer B is formed from AlCrCuN, in which the metallic components are represented by Al_{(*x*)}Cr_{(*y*)}Cu_{(*z*)} (where x+y+z=100 (mol%) and 0<z≤5), and which contains at least N as a nonmetallic element and also contains unavoidable impurities.

Specifically, the nitride layer B of the present example is formed from (Al_{49.5}Cr_{49.5}Cu₁)N and is set to a thickness of 0.01-0.02 µm.

In the nitride layer B, it is possible to apply a configuration in which the Cu content is within the range of 0<z≤5 (mol%), as indicated above. Therefore, the nitride layer B is not limited to (Al_{49.5}Cr_{49.5}Cu₁)N, and may be, e.g., (Al_{49.5}Cr_{49.5}Cu₁)N, (Al₄₉Cr₄₉Cu₂)N, or (Al_{47.5}Cr_{47.5}Cu₅)N.

The nitride layer C is formed from AlX1X2X3X4N (where X1, X2, X3, and X4 are the four metallic elements selected from among Ti, Nb, Cr, V, Ta, Zr, and B), in which, when the four metallic elements other than Al (four metallic elements selected from among Ti, Nb, Cr, V, Ta, Zr, and B) are designated as X1, X2, X3, and X4, the metallic components are represented by Al_{(*a*)}X1_{(*b1*)}X2_{(*b2*)}X3_{(*b3*)}X4_{(*b4*)} (where *a*+*b1*+*b2*+*b3*+*b4*=100 (mol%), 30 mol%≤*a*≤60 mol%, *b1*=*b*±5 mol%, *b2*=*b*±5 mol%, *b3*=*b*±5 mol%, *b4*=*b*±5 mol%, and *b*=(100-*a*)/4), and which contains at least N as a nonmetallic element and also contains unavoidable impurities.

Specifically, the nitride layer C of the present example is formed from AlTiNbCrVN, in which Ti, Nb, Cr, and V are selected as the four metallic elements other than Al, in which the metallic components are represented by Al_{(*a*)}Ti_{(*b1*)}Nb_{(*b2*)}Cr_{(*b3*)}V_{(*b4*)} (where *a*+*b1*+*b2*+*b3*+*b4*=*100* (mol%), 30≤*a*≤60, *b1*=*b*±5 mol%, *b2*=*b*±5 mol%, *b3*=*b*±5 mol%, *b4*=*b*±5 mol%, and *b*=(100-*a*)/4), and which contains at least N as a nonmetallic element and also contains unavoidable impurities.

More specifically, the nitride layer C of the present example is formed from (Al₄₀Ti₁₅Nb₁₅Cr₁₅V₁₅)N and is set to a thickness of 0.01-0.02 µm.

In the nitride layer C, it is possible to apply a configuration in which the Al content is within the range of 30≤*a*≤60 (mol%), as indicated above. Therefore, the nitride layer C is not limited to (Al₄₀Ti₁₅Nb₁₅Cr₁₅V₁₅)N, and may be, e.g., (Al₃₀Ti_{17.5}Nb_{17.5}Cr_{17.5}V_{17.5})N, (Al₅₀Ti_{12.5}Nb_{12.5}Cr_{12.5}V_{12.5})N, or (Al₆₀Ti₁₀Nb₁₀Cr₁₀V₁₀)N.

Additionally, in the nitride layer C, it is preferable for the metallic components other than Al to be present in equivalent amounts. However, as indicated above, it is possible to apply a configuration in which the metallic components are within the range of an offset amount of no more than 5 mol% from the value of the equivalent. Therefore, the nitride layer C may be, e.g., (Al₄₀Ti₂₀Nb₁₀Cr₁₅V₁₅)N, (Al₄₀Ti₁₀Nb₂₀Cr₁₅V₁₅)N, or (Al₄₀Ti₁₅Nb₁₅Cr₁₀V₂₀)N.

Furthermore, the nitride layer C may be composed of a combination of metallic elements other than Ti, Nb, Cr, and V as the four metallic elements other than Al. Specifically, the nitride layer C may be, e.g., AlTiNbCrTaN (replacing V with Ta), AlTiNbCrZrN (replacing V with Zr), AlTiNbCrBN (replacing V with B), AlTiCrZrBN (replacing Nb and V with Zr and B), AlNbCrTaBN (replacing Ti and V with Ta and B), or AlTiNbZrBN (replacing Cr and V with Zr and B).

The first film layer of the present example is obtained by laminating a plurality of these layers in an alternating manner (in sequence). In the present example, the first film layer is configured such that lamination layers formed from the nitride layer A, the nitride layer C, and the nitride layer B, i.e., from (Al₇₀Cr₃₀)N, (Al₄₀Ti₁₅Nb₁₅Cr₁₅V₁₅)N, and (Al_{49.5}Cr_{49.5}Cu₁)N, are repeatedly formed. In the first film layer, the outermost layer may be any of the nitride layer A, the nitride layer B, or the nitride layer C.

The second film layer, which is provided directly under the first film layer and which serves as an intermediate layer in the present example, is obtained by laminating the nitride layer D and the nitride layer E.

Specifically, the nitride layer D is formed from AlCrN, in which the metallic components are represented by Al_{(*m*)}Cr_{(*n*)} (where m+n=100 (mol%)), and which contains at least N as a nonmetallic element and also contains unavoidable impurities.

More specifically, the nitride layer D is formed from (Al₇₀Cr₃₀)N and is set to a thickness of 0.01-0.02 µm.

The nitride layer E is formed from AlCrCuN, in which the metallic components are represented by Al_{(*x*)}Cr_{(*y*)}Cu_{(*z*)} (where x+y+z=100 (mol%) and 0<*z*≤5), and which contains at least N as a nonmetallic element and also contains unavoidable impurities.

Specifically, the nitride layer E is formed from (Al_{49.5}Cr_{49.5}Cu₁)N and is set to a thickness of 0.01-0.02 µm.

Specifically, in the present example, the nitride layer D of the second film layer has the same composition as the nitride layer A of the first film layer, and the nitride layer E of the second film layer has the same composition as the nitride layer B of the first film layer.

The second film layer of the present example is obtained by laminating a plurality of these layers in an alternating manner (in sequence). Specifically, the second film layer is configured such that lamination layers formed from the nitride layer D and the nitride layer E, i.e., from (Al₇₀Cr₃₀)N and (Al_{49.5}Cr_{49.5}Cu₁)N, are repeatedly formed. In the second film layer, the outermost layer, i.e., the layer forming a boundary with the first film layer, may be either of the nitride layer D or the nitride layer E. Additionally, in the second film layer of the present example, a nitride layer having the same compositional ratio as the nitride layer A of the first film layer is employed as the nitride layer D, and a nitride layer having the same compositional ratio as the nitride layer B of the first film layer is employed as the nitride layer E, as described above, but the nitride layer D and the nitride layer E may have compositions different from those of the nitride layer A and the nitride layer B of the first film layer, respectively.

In the second film layer, the amount of Cr in the nitride layer D and the amount of Cr in the nitride layer E are set such that the average value of the amount of Cr in the nitride layer D and the amount of Cr in the nitride layer E is about 30-50 mol% (inclusive) (preferably 40-50 mol% (inclusive)).

Specifically, if the average value of the amount of Cr in the nitride layer D and the amount of Cr in the nitride layer E of the second film layer is 30-50 mol% (inclusive), then excellent abrasion resistance will be exhibited.

Therefore, the second film layer is not limited to the layer configuration of (Al₇₀Cr₃₀)N and (Al_{49.5}Cr_{49.5}Cu₁)N, and may have a layer configuration of, e.g., (Al₅₀Cr₅₀)N and (Al_{49.5}Cr_{49.5}Cu₁)N, (Al₆₀Cr₄₀)N and (Al_{49.5}Cr_{49.5}Cu₁)N, (Al₇₀Cr₃₀)N and (Al_{39.6}Cr_{59.4}Cu₁)N, (Al₇₀Cr₃₀)N and (Al_{59.4}Cr_{39.6}Cu₁)N, (Al₄₀Cr₆₀)N and (Al_{59.4}Cr_{39.6}Cu₁)N, or (Al₇₀Cr₃₀)N and (Al_{69.5}Cr_{29.5}Cu₁)N.

The bottom layer, which is provided directly under the second film layer and directly on the substrate, and which serves as an adhesion layer in the present example, is formed from TiN. The bottom layer improves adhesion between the substrate and the second film layer. The adhesion-improving effect will decrease if the bottom layer is too thin, and the hardness of the hard film for a cutting tool overall will decrease if the bottom layer is too thick; therefore, it is desirable to form the bottom layer at a suitable thickness (0.1-0.5 µm in the present example).

A nitride or carbonitride that has Cr as a main component instead of Ti may be employed as the bottom layer.

The hard film for a cutting tool of the present example may have a configuration in which there is formed a multilayer laminate film in which a plurality of the first film layers and second film layers described above are laminated in an alternating manner. Specifically, the hard film for a cutting tool may have a configuration in which, e.g., a lamination layer obtained by laminating the first film layer and the second film layer is configured as one set, and a plurality of these sets (e.g., four sets) are laminated.

Next, the reasons for configuring the first film layer as described above in the present example are described below.

A variety of experiments and investigations were performed in regard to the first film layer of the present example. Experiment 1 below, which is intended to confirm abrasion resistance, was performed on cutting-tool hard films A1 to A24 shown in table 1 below. The first film layer of the present example was decided upon on the basis of the results of experiment 1.

### (Experiment 1)

First film layers having the layer configurations shown for A1 to A24 in table 1 were formed by arc ion plating on substrates (made of cemented carbide containing tungsten carbide (WC) and cobalt (Co)) of individual cutting tools. For each of the cutting tools, the abrasion width of the hard film for a cutting tool on a flank surface was measured for a case when a workpiece (carbon steel) was subjected to a cutting process under the cutting process conditions A described below. In the present experiment, TiN was formed directly on the substrate as the bottom layer, and the first film layer was formed on the TiN.

### (Cutting process conditions A)

Tool: Cemented-carbide double-edged ball end mill
Tool diameter: 3.0 mm
Coolant: Water-soluble cutting fluid
Rotation speed: 20,000 min⁻¹
Feeding speed: 2.0 m/min
Depth of axial-direction cut: 0.32 mm
Depth of radial-direction cut: 0.9 mm

Processing method: Pocket processing (195 mm long × 45 mm wide × 2.0 mm deep)

**[Table 1]**

| Exper. no. | First film layer | | | Abrasion width (µm) |
|---|---|---|---|---|
| | Nitride layer A | Nitride layer C | Nitride layer B | |
| A1 | (Al₇₀Cr₃₀)N | - | - | 62 |
| A2 | (Al₅₀Cr₅₀)N | - | - | 63 |
| A3 | (Ti₅₀Al₅₀)N | - | - | 164 |
| A4 | (Ti₄₀Al₆₀)N | - | - | 132 |
| A5 | (Al_{57.5}Cr₂₇V₅B_{10.5})N | - | - | 102 |
| A6 | (Al_{61.5}Cr_{28.5}V₅B₅)N | - | - | 137 |
| A7 | (Al_{54.4}Cr_{25.6}V₅B₁₅)N | - | - | 99 |
| A8 | (Al₇₀Ti_{7.5}Nb_{7.5}Ta_{7.5}Cr_{7.5})N | - | - | 130 |
| A9 | (Al₄₀Ti₁₅Nb₁₅Ta₁₅Cr₁₅)N | - | - | 102 |
| A10 | (Al₄₀Ti₁₅Nb₁₅Cr₁₅V₁₅)N | - | - | 108 |
| A11 | (Al₇₀Cr₃₀)N | (Al_{49.5}Cr_{49.5}Cu₁)N | - | 67 |
| A12 | (Al₇₀Cr₃₀)N | (Ti₅₀Al₅₀)N | - | 128 |
| A13 | (Al₇₀Cr₃₀)N | (Al_{57.5}Cr₂₇V₅B_{10.5})N | - | 84 |
| A14 | (Al₇₀Cr₃₀)N | (Al_{61.5}Cr_{28.5}V₅B₅)N | - | 102 |
| A15 | (Al₇ₒCr₃₀)N | (Al_{54.4}Cr_{25.6}V₅B₁₅)N | - | 79 |
| A16 | (Al₇₀Cr₃₀)N | (Al₇₀Ti_{7.5}Nb_{7.5}Cr_{7.5}Ta_{7.5})N | - | 77 |
| A17 | (Al₇₀Cr₃₀)N | (Al₄₀Ti₁₅Nb₁₅Cr₁₅Ta₁₅)N | - | 63 |
| A18 | (Al₇₀Cr₃₀)N | (Al₄₀Ti₁₅Nb₁₅Cr₁₅V₁₅)N | - | 69 |
| A19 | (Al_{49.5}Cr_{49.5}Cu₁)N | (Al_{61.5}Cr_{28.5}V₅B₅)N | - | 68 |
| A20 | (Al_{49.5}Cr_{49.5}Cu₁)N | (Al₄₀Ti₁₅Nb₁₅Cr₁₅Ta₁₅)N | - | 59 |
| A21 | (Al_{49.5}Cr_{49.5}Cu₁)N | (Al₄₀Ti₁₅Nb₁₅Cr₁₅V₁₅)N | - | 66 |
| A22 | (Al₇₀Cr₃₀)N | (Al_{61.5}Cr_{28.5}V₅B₅)N | (Al_{49.5}Cr_{49.5}Cu₁)N | 65 |
| A23 | (Al₇₀Cr₃₀)N | (Al₄₀Ti₁₅Nb₁₅Cr₁₅Ta₁₅)N | (Al_{49.5}Cr_{49.5}Cu₁)N | 54 |
| A24 | (Al₇₀Cr₃₀)N | (Al₄₀Ti₁₅Nb₁₅Cr₁₅V₁₅)N | (Al_{49.5}Cr_{49.5}Cu₁)N | 59 |

As shown in table 1, results were obtained in A17, A20, A23, and A24 such that the abrasion width was equal to or better than that in prior-art examples (A1 and A2). Among these, A20, A23, and A24 yielded results in which the abrasion width was lower (the abrasion resistance was greater) than in the prior-art examples, but in A20 and A23, the generation of droplets was confirmed to be greater than in other examples including the prior-art examples (this effect being thought to originate from the Ta).

Accordingly, in the present example, the configuration indicated in A24, in which the abrasion width was small and droplets were of little concern, was employed as the configuration of the first film layer; specifically, a multilayer-structure film layer formed from (Al₇₀Cr₃₀)N, (Al₄₀Ti₁₅Nb₁₅Cr₁₅V₁₅)N, and (Al_{49.5}Cr_{49.5}Cu₁)N was used as the first film layer, where the (Al₇₀Cr₃₀)N was employed as the nitride layer A, the (Al_{49.5}Cr_{49.5}Cu₁)N was employed as the nitride layer B, and the (Al₄₀Ti₁₅Nb₁₅Cr₁₅V₁₅)N was employed as the nitride layer C.

Next, there are described experimental examples that corroborate the effects of the configurations indicated above other than that formed from (Al₇₀Cr₃₀)N, (Al₄₀Ti₁₅Nb₁₅Cr₁₅V₁₅)N, and (Al_{49.5}Cr_{49.5}Cu₁)N in the first film layer of the present example.

### (Experiment 2)

Experiment 2 was carried out for confirming an appropriate range for the amount of Al in the nitride layer C of the first film layer.

Specifically, in experiment 2, the abrasion width of cutting-tool hard films A25 to A27 indicated in table 2 below, in which the amount of Al in the nitride layer C was changed, was measured through the same experimental method (and under the same cutting process conditions) as in experiment 1 described above.

**[Table 2]**

| Exper. no. | First film layer | | | Abrasion width (µm) |
|---|---|---|---|---|
| | Nitride layer A | Nitride layer C | Nitride layer B | |
| A25 | (Al₇₀Cr₃₀)N | (Al₆₀Ti₁₀Nb₁₀Cr₁₀V₁₀)N | (Al_{49.5}Cr_{49.5}Cu₁)N | 57 |
| A26 | (Al₇₀Cr₃₀)N | (Al₃₀Ti_{17.5}Nb_{17.5}Cr_{17.5}V_{17.5})N | (Al_{49.5}Cr_{49.5}Cu₁)N | 62 |
| A27 | (Al₇₀Cr₃₀)N | (Al₇₂Ti₇Nb₇Cr₇V₇)N | (Al_{49.5}Cr_{49.5}Cu₁)N | 87 |

As shown in table 2, results were obtained in A25 and A26 such that the abrasion width was equal to or worse than that in A24 in experiment 1, in which the abrasion width was 59 µm.

Accordingly, it was confirmed that the appropriate range for the amount of Al in the nitride layer C of the first film layer was 30-60 mol% (inclusive), and that excellent abrasion resistance would be exhibited if the amount of Al in the nitride layer C was within this range.

### (Experiment 3)

Experiment 3 was carried out for confirming an appropriate range for the amounts of metallic components other than Al in the nitride layer C of the first film layer.

Specifically, in experiment 3, the abrasion width of cutting-tool hard films A28 to A36 indicated in table 3 below, in which the amounts of metallic components other than Al in the nitride layer were changed (i.e., in which the amounts of metallic components other than Al were configured to not all be equivalent), was measured through the same experimental method (and under the same cutting process conditions) as in experiment 1 described above.

**[Table 3]**

| Exper. no. | First film layer | | | Abrasion width (µm) | Amount of offset from equivalent |
|---|---|---|---|---|---|
| | Nitride layer A | Nitride layer C | Nitride layer B | | |
| A28 | (Al₇₀Cr₃₀)N | (Al₄₀Ti₂₀Nb₁₀Cr₁₅V₁₅)N | (Al_{49.5}Cr_{49.5}Cu₁)N | 61 | 5 |
| A29 | (Al₇₀Cr₃₀)N | (Al₄₀Ti₁₀Nb₂₀Cr₁₅V₁₅)N | (Al_{49.5}Cr_{49.5}Cu₁)N | 63 | 5 |
| A30 | (Al₇₀Cr₃₀)N | (Al₄₀Ti₂₅Nb₅Cr₁₅V₁₅)N | (Al_{49.5}Cr_{49.5}Cu₁)N | 74 | 10 |
| A31 | (Al₇₀Cr₃₀)N | (Al₄₀Ti₂₉Nb₁Cr₁₅V₁₅)N | (Al_{49.5}Cr_{49.5}Cu₁)N | 96 | 14 |
| A32 | (Al₇₀Cr₃₀)N | (Al₄₀Ti₅Nb₂₅Cr₁₅V₁₅)N | (Al_{49.5}Cr_{49.5}Cu₁)N | 86 | 10 |
| A33 | (Al₇₀Cr₃₀)N | (Al₄₀Ti₂₀Nb₂₀Cr₁₅V₅)N | (Al_{49.5}Cr_{49.5}Cu₁)N | 83 | 10 |
| A34 | (Al₇₀Cr₃₀)N | (Al₄₀Ti₂₀Nb₁₅Cr₂₀V₅)N | (Al_{49.5}Cr_{49.5}Cu₁)N | 78 | 10 |
| A35 | (Al₇₀Cr₃₀)N | (Al₄₀Ti₂₀Nb₅Cr₁₅V₂₀)N | (Al_{49.5}Cr_{49.5}Cu₁)N | 76 | 10 |
| A36 | (Al₇₀Cr₃₀)N | (Al₄₀Ti₁₅Nb₁₅Cr₁₀V₂₀)N | (Al_{49.5}Cr_{49.5}Cu₁)N | 66 | 5 |

As shown in table 3, although there was no example having an abrasion width superior to that in A24 in experiment 1, in which the abrasion width was 59 µm, results were obtained in A28, A29, and A36 such that the abrasion width was substantially equal to that in A24.

Accordingly, it was confirmed that although it is preferable for the metallic components other than Al in the nitride layer C of the first film layer to be present in equivalent amounts, excellent abrasion resistance would be exhibited if the metallic components were within the range of an offset amount of no more than 5 mol% from the value of the equivalent.

### (Experiment 4)

Experiment 4 was carried out for confirming the abrasion resistance in a case where a combination of metallic elements other than Ti, Nb, Cr, and V were selected as the four metallic elements other than Al in the nitride layer C of the first film layer.

Specifically, in experiment 4, the abrasion width of cutting-tool hard films A37 to A43 indicated in table 4 below, in which the combination of four metallic elements other than Al in the nitride layer C was changed, was measured through the same experimental method (and under the same cutting process conditions) as in experiment 1 described above.

**[Table 4]**

| Exper. no. | First film layer | | | Abrasion width (µm) |
|---|---|---|---|---|
| | Nitride layer A | Nitride layer C | Nitride layer B | |
| A37 | (Al₇₀Cr₃₀)N | (Al₄₀Ti₁₅Nb₁₅Cr₁₅Fe₁₅) N | (Al_{49.5}Cr_{49.5}Cu₁)N | 133 |
| A38 | (Al₇₀Cr₃₀)N | (Al₄₀Ti₁₅Nb₁₅Cr₁₅Zr₁₅) N | (Al_{49.5}Cr_{49.5}Cu₁)N | 64 |
| A39 | (Al₇₀Cr₃₀)N | (Al₄₀Ti₁₅Nb₁₅Cr₁₅B₁₅)N | (Al_{49.5}Cr_{49.5}Cu₁)N | 61 |
| A40 | (Al₇₀Cr₃₀)N | (Al₆₀Ti₁₀Cr₁₀Zr₁₀B₁₀)N | (Al_{49.5}Cr_{49.5}Cu₁)N | 59 |
| A41 | (Al₇₀Cr₃₀)N | (Al₆₀Nb₁₀Cr₁₀Ta₁₀B₁₀)N | (Al_{49.5}Cr_{49.5}Cu₁)N | 61 |
| A42 | (Al₇₀Cr₃₀)N | (Al₆₀Ti₁₀Nb₁₀Zr₁₀B₁₀)N | (Al_{49.5}Cr_{49.5}Cu₁)N | 63 |
| A43 | (Al₇₀Cr₃₀)N | (Al₆₀Ti₁₀Nb₁₀Fe₁₀B₁₀)N | (Al_{49.5}Cr_{49.5}Cu₁)N | Snapped |

As shown in table 4, although there was no example having an abrasion width superior to that in A24 in experiment 1, in which the abrasion width was 59 µm, results were obtained in A38 to A42 such that the abrasion width was substantially equal to that in A24.

Accordingly, it was confirmed that excellent abrasion resistance was exhibited even when some metallic elements other than Al in the nitride layer C from among Ti, Nb, Cr, and V were replaced with Ta, Zr, or B.

Next, the reasons for configuring the second film layer as described above in the present example are described below.

A variety of experiments and investigations were performed in regard to the second film layer of the present example in the same manner as with the first film layer. Experiment 5 below, which is intended to confirm abrasion resistance, was finally performed on cutting-tool hard films B2 to B6 shown in table 5 below. The second film layer of the present invention was decided upon on the basis of the results of experiment 5.

### (Experiment 5)

Second film layers having the compositions shown for B2 to B6 in table 5 were formed by arc ion plating on substrates (made of cemented carbide containing tungsten carbide (WC) and cobalt (Co)) of individual cutting tools. Coatings formed from the (Al₇₀Cr₃₀)N, (Al₄₀Ti₁₅Nb₁₅Cr₁₅V₁₅)N, and (Al_{49.5}Cr_{49.5}Cu₁)N determined according to experiment 1 were formed as the first film layers on the second film layers. The abrasion width of the hard film for a cutting tool on a flank surface was measured for a case when a workpiece (pre-hardened steel) was subjected to a cutting process using each of the cutting tools under the cutting process conditions B described below. B1 was a prior-art example having the same configuration as A1 in experiment 1. In the present experiment, TiN was formed directly on the substrate as the bottom layer (adhesion layer), the first film layer was formed on the TiN in the case of B1, and the second film layer was formed on the TiN in the case of B2 to B6.

In the present experiment, the thickness of the first film layer was about 1.2 µm, and the thickness of the second film layer was about 2.4 µm.

### (Cutting process conditions B)

Tool: Cemented-carbide double-edged ball end mill
Tool diameter: 3.0 mm
Coolant: Water-soluble cutting fluid
Rotation speed: 20,000 min⁻¹
Feeding speed: 2.0 m/min
Depth of axial-direction cut: 0.32 mm
Depth of radial-direction cut: 0.9 mm
Processing method: Pocket processing (195 mm long × 30 mm wide × 3.0 mm deep)

**[Table 5]**

| Experiment no. | Composition | | | Abrasion width (µm) |
|---|---|---|---|---|
| B1 | First film layer | Nitride layer A | (Al₇₀Cr₃₀)N | 50.2 |
| | | Nitride layer C | | |
| | | Nitride layer B | | |
| | Second film layer | Nitride layer D | - | |
| | | Nitride layer E | - | |
| B2 | First film layer | Nitride layer A | (Al₇₀Cr₃₀)N | 43.6 |
| | | Nitride layer C | (Al₄₀Ti₁₅Nb₁₅Cr₁₅Vr₁₅)N | |
| | | Nitride layer B | (Al_{49.5}Cr_{49.5}Cu₁)N | |
| | Second film layer | Nitride layer D | (Al₇₀Cr₃₀)N | |
| | | Nitride layer E | - | |
| B3 | First film layer | Nitride layer A | (Al₇₀Cr₃₀)N | 29.3 |
| | | Nitride layer C | (Al₄₀Ti₁₅Nb₁₅Cr₁₅Vr₁₅)N | |
| | | Nitride layer B | (Al_{49.5}Cr_{49.5}Cu₁)N | |
| | Second film layer | Nitride layer D | (Al_{49.5}Cr_{49.5}Cu₁)N | |
| | | Nitride layer E | - | |
| B4 | First film layer | Nitride layer A | (Al₇₀Cr₃₀)N | 28.5 |
| | | Nitride layer C | (Al₄₀Ti₁₅Nb₁₅Cr₁₅Vr₁₅)N | |
| | | Nitride layer B | (Al_{49.5}Cr_{49.5}Cu₁)N | |
| | Second film layer | Nitride layer D | (Al₇₀Cr₃₀)N | |
| | | Nitride layer E | (Al_{49.5}Cr_{49.5}Cu₁)N | |
| B5 | First film layer | Nitride layer A | (Al₇₀Cr₃₀)N | 48.2 |
| | | Nitride layer C | (Al₄₀Ti₁₅Nb₁₅Cr₁₅Vr₁₅)N | |
| | | Nitride layer B | (Al_{49.5}Cr_{49.5}Cu₁)N | |
| | Second film layer | Nitride layer D | (Al₇₀Cr₃₀)N | |
| | | Nitride layer E | (Al₄₀Ti₁₅Nb₁₅Cr₁₅Vr₁₅)N | |
| B6 | First film layer | Nitride layer A | (Al₇₀Cr₃₀)N | 37.2 |
| | | Nitride layer C | (Al₄₀Ti₁₅Nb₁₅Cr₁₅Vr₁₅)N | |
| | | Nitride layer B | (Al_{49.5}Cr_{49.5}Cu₁)N | |
| | Second film layer | Nitride layer D | (Al_{49.5}Cr_{49.5}Cu₁)N | |
| | | Nitride layer E | (Al₄₀Ti₁₅Nb₁₅Cr₁₅Vr₁₅)N | |

As shown in table 5, results were obtained in the cutting-tool hard films in all of B2 to B6, in which the second film layer is provided under the first film layer, such that the abrasion width decreased (the abrasion resistance improved) to a greater extent than in the prior-art example (B1). Among these, B4, in which the second film layer was formed in a layered structure of (Al₇₀Cr₃₀)N and (Al_{49.5}Cr_{49.5}Cu₁)N, yielded the result in which the abrasion width was smallest (the abrasion resistance was most greatly improved).

Accordingly, in the present example, the configuration indicated in B4, in which the abrasion width decreased (the abrasion width improved), was employed as the configuration of the second film layer; specifically, a multilayer-structure film layer formed from (Al₇₀Cr₃₀)N and (Al_{49.5}Cr_{49.5}Cu₁)N was used as the second film layer, where the (Al₇₀Cr₃₀)N was employed as the nitride layer D, and the (Al_{49.5}Cr_{49.5}Cu₁)N was employed as the nitride layer E.

Next, there are described experimental examples that corroborate the effects of the configurations indicated above other than that formed from (Al₇₀Cr₃₀)N and (Al_{49.5}Cr_{49.5}Cu₁)N in the second film layer of the present example.

### (Experiment 6)

Experiment 6 was carried out for confirming an appropriate range for the amount of Cu in each of the nitride layer B of the first film layer and the nitride layer E of the second film layer.

Specifically, in experiment 6, the abrasion width of cutting-tool hard films B7 to B10 indicated in table 6 below, in which the amount of Cu in each of the nitride layer B of the first film layer and the nitride layer E of the second film layer was changed, was measured through the same experimental method (and under the same cutting process conditions) as in experiment 5 described above.

**[Table 6]**

| Experiment no. | Composition | | | Abrasion width (µm) |
|---|---|---|---|---|
| B7 | First film layer | Nitride layer A | (Al₇₀Cr₃₀)N | 39.2 |
| | | Nitride layer C | (Al₄₀Ti₁₅Nb₁₅Cr₁₅Vr₁₅)N | |
| | | Nitride layer B | (Al₅₀Cr₅₀)N | |
| | Second film layer | Nitride layer D | (Al₇₀Cr₃₀)N | |
| | | Nitride layer E | (Al₅₀Cr₅₀)N | |
| B8 | First film layer | Nitride layer A | (Al₇₀Cr₃₀)N | 29.5 |
| | | Nitride layer C | (Al₄₀Ti₁₅Nb₁₅Cr₁₅Vr₁₅)N | |
| | | Nitride layer B | (Al₄₉Cr₄₉Cu₂)N | |
| | Second film layer | Nitride layer D | (Al₇₀Cr₃₀)N | |
| | | Nitride layer E | (Al₄₉Cr₄₉Cu₂)N | |
| B9 | First film layer | Nitride layer A | (Al₇₀Cr₃₀)N | 33.2 |
| | | Nitride layer C | (Al₄₀Ti₁₅Nb₁₅Cr₁₅Vr₁₅)N | |
| | | Nitride layer B | (Al_{47.5}Cr_{47.5}Cu₅)N | |
| | Second film layer | Nitride layer D | (Al₇₀Cr₃₀)N | |
| | | Nitride layer E | (Al₄₇.₅Cr₄₇.₅CU₅) N | |
| B10 | First film layer | Nitride layer A | (Al₇₀Cr₃₀)N | 56.8 |
| | | Nitride layer C | (Al₄₀Ti₁₅Nb₁₅Cr₁₅Vr₁₅)N | |
| | | Nitride layer B | (Al_{46.5}Cr_{46.5}Cu₇)N | |
| | Second film layer | Nitride layer D | (Al₇₀Cr₃₀)N | |
| | | Nitride layer E | (Al_{46.5}Cr_{46.5}Cu₇)N | |

As shown in table 6, results were obtained in B7 to B9 such that the abrasion width decreased (the abrasion resistance improved) to a greater extent than in the prior-art example (B1 in experiment 5), in which the abrasion width was 50.2 µm. Among these, B8 and B9 yielded results in which the abrasion width was substantially equal to that in B3 of experiment 5.

Accordingly, in view of the results of experiment 5, it was confirmed that excellent abrasion resistance would be exhibited if the amount of Cu in each of the nitride layer B of the first film layer and the nitride layer E of the second film layer was greater than 0 and no greater than 5 mol%.

### (Experiment 7)

Experiment 7 was carried out for confirming an appropriate range for the amount of Cr in each of the nitride layer D and the nitride layer E of the second film layer.

Specifically, in experiment 7, the abrasion width of cutting-tool hard films B11 to B17 indicated in table 7 below, in which the amount of Cr in each of the nitride layer D and the nitride layer E of the second film layer was changed, was measured through the same experimental method (and under the same cutting process conditions) as in experiment 5 described above.

**[Table 7]**

| Experiment no. | Composition | | | Abrasion width (µm) |
|---|---|---|---|---|
| B11 | First film layer | Nitride layer A | (Al₅₀Cr₅₀)N | 29.0 |
| | | Nitride layer C | (Al₄₀Ti₁₅Nb₁₅Cr₁₅V₁₅)N | |
| | | Nitride layer B | (Al_{49.5}Cr_{49.5}Cu₁)N | |
| | Second film layer | Nitride layer D | (Al₅₀Cr₅₀)N | |
| | | Nitride layer E | (Al_{49.5}Cr_{49.5}Cu₁)N | |
| B12 | First film layer | Nitride layer A | (Al₄₀Cr₆₀)N | 63.5 |
| | | Nitride layer C | (Al₄₀Ti₁₅Nb₁₅Cr₁₅V₁₅)N | |
| | | Nitride layer B | (Al_{49.5}Cr_{49.5}Cu₁)N | |
| | Second film layer | Nitride layer D | (Al₄₀Cr₆₀)N | |
| | | Nitride layer E | (Al_{49.5}Cr_{49.5}Cu₁)N | |
| B13 | First film layer | Nitride layer A | (Al₆₀Cr₄₀)N | 28.8 |
| | | Nitride layer C | (Al₄₀Ti₁₅Nb₁₅Cr₁₅V₁₅)N | |
| | | Nitride layer B | (Al_{49.5}Cr_{49.5}Cu₁)N | |
| | Second film layer | Nitride layer D | (Al₆₀Cr₄₀)N | |
| | | Nitride layer E | (Al_{49.5}Cr_{49.5}Cu₁)N | |
| B14 | First film layer | Nitride layer A | (Al₇₀Cr₃₀)N | 31.2 |
| | | Nitride layer C | (Al₄₀Ti₁₅Nb₁₅Cr₁₅V₁₅)N | |
| | | Nitride layer B | (Al_{39.6}Cr_{59.4}Cu₁)N | |
| | Second film layer | Nitride layer D | (Al₇₀Cr₃₀)N | |
| | | Nitride layer E | (Al_{39.6}Cr_{59.4}Cu₁)N | |
| B15 | First film layer | Nitride layer A | (Al₇₀Cr₃₀)N | 34.1 |
| | | Nitride layer C | (Al₄₀Ti₁₅Nb₁₅Cr₁₅V₁₅)N | |
| | | Nitride layer B | (Al_{59.4}Cr_{39.6}Cu₁)N | |
| | Second film layer | Nitride layer D | (Al₇₀Cr₃₀)N | |
| | | Nitride layer E | (Al_{59.4}Cr_{39.6}Cu₁)N | |
| B16 | First film layer | Nitride layer A | (Al₄₀Cr₆₀)N | 30.6 |
| | | Nitride layer C | (Al₄₀Ti₁₅Nb₁₅Cr₁₅V₁₅)N | |
| | | Nitride layer B | (Al_{59.4}Cr_{39.6}Cu₁)N | |
| | Second film layer | Nitride layer D | (Al₄₀Cr₆₀)N | |
| | | Nitride layer E | (Al_{59.4}Cr_{39.6}Cu₁)N | |
| B17 | First film layer | Nitride layer A | (Al₇₀Cr₃₀)N | 37.8 |
| | | Nitride layer C | (Al₄₀Ti₁₅Nb₁₅Cr₁₅V₁₅)N | |
| | | Nitride layer B | (Al_{69.5}Cr_{29.5}Cu₁)N | |
| | Second film layer | Nitride layer D | (Al₇₀Cr₃₀)N | |
| | | Nitride layer E | (Al_{69.5}Cr_{29.5}Cu₁)N | |

As shown in table 7, results were obtained in all cutting-tool hard films other than B12 such that the abrasion width decreased (the abrasion resistance improved) to a greater extent than in the prior-art example (B1 in experiment 5), in which the abrasion width was 50.2 µm.

In B12, the average value of the amount of Cr in the nitride layer D and the amount of Cr in the nitride layer E was greater than 50 mol% (about 55 mol%), but in the cutting-tool hard films other than B12, the average value of the amount of Cr in the nitride layer D and the amount of Cr in the nitride layer E was about 30-50 mol% (inclusive).

Accordingly, it was confirmed that excellent abrasion resistance would be exhibited if the average value of the amount of Cr in the nitride layer D and the amount of Cr in the nitride layer E of the second film layer was about 30-50 mol% (inclusive) (preferably 40-50 mol% (inclusive)).

### (Experiment 8)

In consideration of the results of experiment 5 as well as experiments 2 and 4 relating to the first film layer, experiment 8 was carried out for confirming the abrasion resistance in a case where the compositional ratio, specifically the amount of Al, in the nitride layer C of the first film layer was changed (in the present experiment, a case where the amount of Al was changed from 40 mol% to 60 mol%), and in a case where a composition was adopted in which a combination of metallic elements other than Ti, Nb, Cr, and V were selected as the four metallic elements other than Al in the nitride layer C (in the present experiment, a case where Ti, Nb, Cr, and B were selected (where V was replaced with B)).

Specifically, in experiment 8, the abrasion width of cutting-tool hard films B18 and B19 indicated in table 8 below was measured through the same experimental method (and under the same cutting process conditions) as in experiment 5 described above.

**[Table 8]**

| Experiment no. | Composition | | | Abrasion width (µm) |
|---|---|---|---|---|
| B18 | First film layer | Nitride layer A | (Al₇₀Cr₃₀)N | 28.0 |
| | | Nitride layer C | (Al₆₀Ti₁₀Nb₁₀Cr₁₀Vr₁₀)N | |
| | | Nitride layer B | (Al_{49.5}Cr_{49.5}Cu₁)N | |
| | Second film layer | Nitride layer D | (Al₇₀Cr₃₀)N | |
| | | Nitride layer E | (Al_{49.5}Cr_{49.5}Cu₁)N | |
| B19 | First film layer | Nitride layer A | (Al₇₀Cr₃₀)N | 29.2 |
| | | Nitride layer C | (Al₄₀Ti₁₅Nb₁₅Cr₁₅B₁₅)N | |
| | | Nitride layer B | (Al_{49.5}Cr_{49.5}Cu₁)N | |
| | Second film layer | Nitride layer D | (Al₇₀Cr₃₀)N | |
| | | Nitride layer E | (Al_{49.5}Cr_{49.5}Cu₁)N | |

As shown in table 8, results were obtained in both of B18 and B19 such that the abrasion width decreased (the abrasion resistance improved) to a greater extent than in the prior-art example (B1 in experiment 5), in which the abrasion width was 50.2 µm.

Accordingly, it was confirmed that excellent abrasion resistance would be exhibited if the amount of Al in the nitride layer C was 30-60 mol% (inclusive), and even when some metallic elements other than Al in the nitride layer C from among Ti, Nb, Cr, and V were replaced with Ta, Zr, or B.

### [Example 2]

A specific example 2 of the present invention is described below.

The present example relates to a case where the configuration (composition) of the nitride layer C of the first film layer differs from that in example 1.

Specifically, the present example relates to a case where the nitride layer C of the first film layer is formed from a nitride layer that is formed from Al and five or six metallic elements selected from among Ti, Nb, Cr, V, Ta, Zr, and B and that contains unavoidable impurities.

The present invention is described in detail below. However, because the configuration of the first film layer in the present example is the same as that in example 1 except for the nitride layer C, the configuration other than that for the nitride layer C is not described here.

In the nitride layer C of the present example, when five metallic elements (X1, X2, X3, X4, X5) selected from among Ti, Nb, Cr, V, Ta, Zr, and B are employed as the metallic elements other than Al, the metallic components are represented by Al_{(*a*)}X1_{(*b1*)}X2_{(*b2*)}X3_{(*b3*)}X4_{(*b4*)}X5_{(*b5*)} (where *a*+*b1*+*b2*+*b3*+*b4*+*b5*=100 (mol%), 30 mol%≤*a*≤60 mol%, *b1*=*b*±5 mol%, *b2*=*b*±5 mol%, *b3*=*b*±5 mol%, *b4*=*b*±5 mol%, *b5*=*b*±5 mol%, and *b*=(100*-a*)/5)*.* Moreover, when six metallic elements (X1, X2, X3, X4, X5, X6) selected from among Ti, Nb, Cr, V, Ta, Zr, and B are employed as the metallic elements other than Al, the metallic components are represented by Al₍ₐ₎X1_{(*b1*)}X2_{(*b2*)}X3_{(*b3*)}X4_{(*b4*)}X5_{(*b5*)}X6_{(*b6*)} (where *a*+*b2*+*b2*+*b3*+*b4*+*b5*+*b6*=100 (mol%), 30 mol%≤*a*≤60 mol%, *b1*=*b*±5 mol%, *b2*=*b*±5 mol%, *b3*=*b*±5 mol%, *b4*=*b*±5 mol%, *b5*=*b*±5 mol%, *b6*=*b*±5 mol%, and *b*=(100-*a*)/6).

Specifically, the nitride layer C of the present example is formed from AlTiNbCrVBN, in which Ti, Nb, Cr, V, and B are selected as the five metallic elements other than Al, in which the metallic components are represented by Al_{(*a*)}Ti_{(*b1*)}Nb_{(*b2*)}Cr_{(*b3*)}V_{(*b4*)}B_{(*b5*)} (where *a*+*b1*+*b2*+*b3*+*b4*+*b5*=100 (mol%), 30≤*a*≤60, *b1*=*b*±5 mol%, *b2*=*b*±5 mol%, *b3*=*b*±5 mol%, *b4*=*b*±5 mol%, *b5*=*b*±5 mol%, and *b*=(100-*a*)15)*,* and which contains at least N as a nonmetallic element and also contains unavoidable impurities.

More specifically, the nitride layer C of the present example is formed from (Al₄₀Ti₁₂Nb₁₂Cr₁₂V₁₂B₁₂)N and is set to a thickness of 0.01-0.02 µm.

The nitride layer C is not limited to the composition described above. For example, Ta or Zr may be selected instead of B (B may be replaced with Ta or Zr). Moreover, a plurality of metallic elements may be replaced, rather than replacing one metallic element as described above. Furthermore, the nitride layer C may be formed such that six metallic elements selected from among Ti, Nb, Cr, V, Ta, Zr, and B are employed as the metallic elements other than Al (e.g., the nitride layer C may be formed from AlTiNbZrCrVBN, etc.).

Next, experimental examples that corroborate the effects of the present example are described.

### (Experiment 9)

First film layers having the layer configurations shown for C1 and C2 in table 9 were formed by arc ion plating on substrates (made of cemented carbide containing tungsten carbide (WC) and cobalt (Co)) of individual cutting tools. For each of the cutting tools, the abrasion width of the hard film for a cutting tool on a flank surface was measured for a case when a workpiece (carbon steel) was subjected to a cutting process under the cutting process conditions C described below. In the present experiment, TiN was formed directly on the substrate as the bottom layer, and the first film layer was formed on the TiN.

### (Cutting process conditions C)

Tool: Cemented-carbide double-edged ball end mill
Tool diameter: 3.0 mm
Coolant: Water-soluble cutting fluid
Rotation speed: 20,000 min⁻¹
Feeding speed: 2.0 m/min
Depth of axial-direction cut: 0.32 mm
Depth of radial-direction cut: 0.9 mm
Processing method: Pocket processing (195 mm long × 45 mm wide × 2.0 mm deep)

**[Table 9]**

| Experiment no. | First film layer | | | Abrasion width (µm) |
|---|---|---|---|---|
| | Nitride layer A | Nitride layer C | Nitride layer B | |
| C1 | (Al₇₀Cr₃₀)N | (Al₄₀Ti₁₂Nb₁₂Cr₁₂V₁₂B₁₂)N | (Al_{49.5}Cr_{49.5}Cu₁)N | 58 |
| C2 | (Al₇₀Cr₃₀)N | (Al₄₀Ti₁₀Nb₁₀Zr₁₀Cr₁₀V₁₀B₁₀)N | (Al_{49.5}Cr_{49.5}Cu₁)N | 62 |

As shown in table 9, results were obtained in both of these cutting-tool hard films such that that abrasion width was equal to or lower than that in the prior-art examples (A1 and A2 in experiment 1 of example 1). In addition, it was confirmed that the same degree of abrasion width (abrasion resistance) was obtained as in A24 in experiment 1 of example 1.

### (Experiment 10)

A second film layer and a first film layer having the compositions shown for C3 in table 10 were formed by arc ion plating on a substrate (made of cemented carbide containing tungsten carbide (WC) and cobalt (Co)) of a cutting tool. The abrasion width of the hard film for a cutting tool on a flank surface was measured for a case when a workpiece (pre-hardened steel) was subjected to a cutting process using the cutting tool under the cutting process conditions D described below.

In the present experiment, TiN was formed directly on the substrate as the bottom layer (adhesion layer), and the second film layer was formed on the TiN. Additionally, in the present experiment, the thickness of the first film layer was about 1.2 µm, and the thickness of the second film layer was about 2.4 µm.

### (Cutting process conditions D)

Tool: Cemented-carbide double-edged ball end mill
Tool diameter: 3.0 mm
Coolant: Water-soluble cutting fluid
Rotation speed: 20,000 min⁻¹
Feeding speed: 2.0 m/min
Depth of axial-direction cut: 0.32 mm
Depth of radial-direction cut: 0.9 mm
Processing method: Pocket processing (195 mm long × 30 mm wide × 3.0 mm deep)

**[Table 10]**

| Experiment no. | Composition | | | Abrasion width (µm) |
|---|---|---|---|---|
| C3 | First film layer | Nitride layer A | (Al₇₀Cr₃₀)N | 28.6 |
| | | Nitride layer C | (Al₄₀Ti₁₂Nb₁₂Cr₁₂V₁₂B₁₂)N | |
| | | Nitride layer B | (Al_{49.5}Cr_{49.5}Cu₁)N | |
| | Second film layer | Nitride layer D | (Al₇₀Cr₃₀)N | |
| | | Nitride layer E | (Al_{49.5}Cr_{49.5}Cu₁)N | |

As shown in table 10, results were obtained such that the abrasion width decreased (the abrasion resistance improved) to a greater extent than in the prior-art example (B1 in experiment 5 of example 1), in which the abrasion width was 50.2 µm. In addition, it was confirmed that the same degree of abrasion width (abrasion resistance) was obtained as in B3 in example 5 of example 1.

The present invention is not limited to examples 1 and 2. The specific configurations of the various constituent elements can be designed, as appropriate.

It is explicitly stated that all features disclosed in the description and/or the claims are intended to be disclosed separately and independently from each other for the purpose of original disclosure as well as for the purpose of restricting the claimed invention independent of the composition of the features in the embodiments and/or the claims. It is explicitly stated that all value ranges or indications of groups of entities disclose every possible intermediate value or intermediate entity for the purpose of original disclosure as well as for the purpose of restricting the claimed invention, in particular as limits of value ranges.

## Claims

1. A hard film for a cutting tool that is formed on a substrate, the hard film for a cutting tool being **characterized in that**: a first film layer that comes in contact with a workpiece is included therein, the first film layer being obtained by laminating one or both of a nitride layer A that is formed from Al and Cr and that contains unavoidable impurities, and a nitride layer B that is formed from Al, Cr, and Cu and that contains unavoidable impurities, together with a nitride layer C that is formed from Al and four elements selected from among Ti, Nb, Cr, V, Ta, Zr, and B and that contains unavoidable impurities; the amount of Al in the nitride layer C is 30-60 mol% (inclusive); and the amounts of the elements other than Al in the nitride layer C are within ±5 mol% of the equivalent (equivalent: (100-(amount of Al in nitride layer C))/4).

2. The hard film for a cutting tool according to claim 1, **characterized in that** the first film layer is obtained by laminating a plurality of nitride layers A and nitride layers C.

3. The hard film for a cutting tool according to claim 1, **characterized in that** the first film layer is obtained by laminating a plurality of nitride layers B and nitride layers C.

4. The hard film for a cutting tool according to claim 1, **characterized in that** the first film layer is obtained by laminating a plurality of nitride layers A, nitride layers B, and nitride layers C.

5. The hard film for a cutting tool according to any of claims 1, 3, and 4, **characterized in that** the amount of Cu in the nitride layer B is 5 mol% or less.

6. The hard film for a cutting tool according to any of claims 1 to 5, **characterized by** being formed from the first film layer and a second film layer provided under the first film layer, the second film layer being a nitride layer D that is formed from Al and Cr and that contains unavoidable impurities, or a nitride layer E that is formed from Al, Cr, and Cu and that contains unavoidable impurities.

7. The hard film for a cutting tool according to claim 6, **characterized in that** the second film layer is the nitride layer D, and the amount of Cr in the nitride layer D is 30-50 mol% (inclusive).

8. The hard film for a cutting tool according to claim 6 or 7, **characterized in that** the nitride layer D has the same composition as the nitride layer A.

9. The hard film for a cutting tool according to claim 6, **characterized in that** the second film layer is the nitride layer E, and the amount of Cr in the nitride layer E is 30-50 mol% (inclusive).

10. The hard film for a cutting tool according to claim 6 or 9, **characterized in that** the nitride layer E has the same composition as the nitride layer B.

11. The hard film for a cutting tool according to any of claims 1 to 5, **characterized by** being formed from the first film layer and a second film layer provided under the first film layer, the second film layer being obtained by laminating a nitride layer D that is formed from Al and Cr and that contains unavoidable impurities, and a nitride layer E that is formed from Al, Cr, and Cu and that contains unavoidable impurities.

12. The hard film for a cutting tool according to claim 11, **characterized in that** the average value of the amounts of Cr in each of the nitride layer D and the nitride layer E of the second film layer is 30-50 mol% (inclusive).

13. The hard film layer for a cutting tool according to claim 11 or 12, **characterized in that** the nitride layer D has the same composition as the nitride layer A, and the nitride layer E has the same composition as the nitride layer B.

14. The hard film for a cutting tool according to any of claims 11 to 13, **characterized in that** the second film layer is obtained by laminating a plurality of nitride layers D and nitride layers E.

15. The hard film for a cutting tool according to any of claims 6 and 9 to 14, **characterized in that** the amount of Cu in the nitride layer E is 5 mol% or less.

16. The hard film for a cutting tool according to claim 1, **characterized in that**: the first film layer is obtained by laminating the nitride layer A, the nitride layer B, and the nitride layer C; the nitride layer A is formed from (Al₇₀Cr₃₀)N, in which the metallic components are represented by Al₇₀Cr₃₀ (the numerals expressing the molar percentage), and which contains at least N as a nonmetallic element and also contains unavoidable impurities; the nitride layer B is formed from (Al_{49.5}Cr_{49.5}Cu₁)N, in which the metallic components are represented by Al_{49.5}Cr_{49.5}Cu₁ (the numerals expressing the molar percentage), and which contains at least N as a nonmetallic element and also contains unavoidable impurities; and the nitride layer C is formed from (Al₄₀Ti₁₅Nb₁₅Cr₁₅V₁₅)N, in which the metallic components are represented by Al₄₀Ti₁₅Nb₁₅Cr₁₅V₁₅ (the numerals expressing the molar percentage), and which contains at least N as a nonmetallic element and also contains unavoidable impurities.

17. The hard film for a cutting tool according to claim 16, **characterized by** being formed from the first film layer and a second film layer provided under the first film layer, the second film layer being obtained by laminating a nitride layer D that is formed from Al and Cr and that contains unavoidable impurities, and a nitride layer E that is formed from Al, Cr, and Cu and that contains unavoidable impurities, the nitride layer D having the same composition as the nitride layer A, and the nitride layer E having the same composition as the nitride layer B.

18. The hard film for a cutting tool according to any of claims 1 to 17, **characterized by** having a bottom layer formed directly on the substrate, the bottom layer being formed from a nitride or carbonitride of Ti.
